Europäisches Patentamt

European Patent Office

Office européen des brevets

(19)

(11) Numéro de publication: **0 079 831**

**A1**

(12)

# DEMANDE DE BREVET EUROPEEN

(21) Numéro de dépôt: **82402067.1**

(22) Date de dépôt: **10.11.82**

(51) Int. Cl.³: **H 03 K 13/24**
**G 05 B 19/10**

(30) Priorité: **12.11.81 FR 8121184**

(43) Date de publication de la demande:
**25.05.83 Bulletin 83/21**

(84) Etats contractants désignés:
**AT BE CH DE GB IT LI LU NL SE**

(71) Demandeur: INNOVATION TECHNIQUE S.A.M. en
abrégé INNOTEC Société dite:
Les Industries rue du Stade
Monaco(MC)

(72) Inventeur: Grandclement, Gérard
89 Avenue du 3 Septembre
F-06320 Cap D'Ail(FR)

(74) Mandataire: Polus, Camille et al,
c/o Cabinet Lavoix 2, Place d'Estienne d'Orves
F-75441 Paris Cedex 09(FR)

(54) Générateur séquentiel à commande manuelle d'un code binaire.

(57) Générateur séquentiel à commande manuelle d'un code binaire à $n$ nombres successifs, caractérisé en ce qu'il comprend au moins un organe manuel de commande (4) destiné à engendrer successivement au moins certains des $n$ nombres du code binaire, respectivement au cours d'autant de séquences de codage successives, une mémoire (7) qui est destinée à emmagasiner successivement lesdits nombres de code et à la sortie (17) de laquelle apparaîtra ledit code binaire, un générateur de référence temporelle (5), des moyens de détection (10) capables de fournir un signal de fin de séquence lorsqu'ils détectent une durée séparant deux actionnements consécutifs sur ledit organe manuel de commande (4), supérieure à ladite référence temporelle et des moyens de validation (11,12) qui en réponse audit signal de fin de séquence vident ladite mémoire (7) en transmettant le contenu de celle-ci vers ladite sortie (17).

./...

**FIG.2B**

"GENERATEUR SEQUENTIEL A COMMANDE MANUELLE D'UN CODE BINAIRE".

La présente invention est relative à un générateur séquentiel de codage à commande manuelle, dans lequel un organe unique de commande est destiné à engendrer successivement des impulsions relatives à un code chiffré devant être obtenu au cours de séquences de codage successives, cet organe de codage étant connecté à un générateur d'une référence temporelle à laquelle est confrontée l'intervalle de temps séparant deux actions successives sur l'organe de codage pour permettre d'affecter un rang à chaque chiffre dudit code choisi à chaque séquence, le générateur comportant en outre une mémoire destinée à emmagasiner le nombre d'impulsions engendrées au cours de chaque séquence.

Un générateur de ce type est décrit dans le DE-A-2.952.212. Dans ce cas, le générateur est destiné à engendrer un code chiffré qui, lorsqu'il correspond à un code mis en mémoire, autorise l'actionnement d'une serrure. La commande manuelle du générateur est alors assurée par l'intermédiaire du bouton de sonnette associé à la porte dont la serrure assure la fermeture.

Ce montage connu présente un premier inconvénient qui réside dans sa réalisation à partir de moyens entièrement électromécaniques dont la fiabilité, l'encombrement et le coût laissent à désirer et qui surtout ne cadrent pas avec les besoins en miniaturisation qui sont actuellement à l'ordre du jour.

En outre, le générateur en tant que tel ne peut fournir à sa sortie que des signaux d'autorisation qui bien que basés sur la reconnaissance d'un nombre décimal bien déterminé, ne se prête pas à un traitement binaire. Ainsi, par exemple, lorsque l'utilisateur introduit sept impulsions (premier chiffre codé dans l'exemple décrit dans ce brevet

2

antérieur), il en résulte simplement l'excitation d'un relais, le nombre sept ne se traduisant pas par un code déterminé susceptible d'être utilisé pour un traitement binaire ultérieur.

Cet inconvénient en entraîne d'ailleurs un autre qui consiste en ce que le code, s'il est constitué de plusieurs chiffres, ne peut comporter des chiffres identiques placés à des rangs différents, car le montage ne pourrait alors fonctionner correctement. Un générateur conçu suivant le brevet allemand précité perd donc alors beaucoup de son intérêt.

On sait également réaliser des générateurs qui fournissent en sortie une information binaire. Il s'agit des claviers à dix touches dont chacune est affectée d'une valeur numérique pouvant aller de 1 à 0 (voir par exemple le brevet américain N° 3.601.574). D'autres claviers de type alphanumérique, permettant de coder une quantité d'information nettement plus grande en fonction de systèmes de codage normalisés (code ASCII, par exemple).

Dans de nombreuses applications, ces claviers connus donnent entièrement satisfaction, mais dans d'autres, ils sont entachés de deux inconvénients majeurs. Le premier de ces inconvénients consiste en ce qu'ils sont relativement encombrants et il y a donc une limite à la miniaturisation de certains appareils électroniques (calculatrices électroniques, claviers de serrures électroniques, cadrans de postes téléphoniques sans fil, radio-commandes, etc.). Le second inconvénient réside dans le fait que chaque touche d'un tel clavier ne peut donner lieu à la génération que d'une information préprogrammée déterminée par le câblage du clavier, de sorte que la capacité d'information par touche que celui-ci peut engendrer est limitée en conséquence.

On connaît enfin d'après le brevet américain N°4.250.401 un générateur de codage ne comportant que trois touches d'actionnement, mais dans ce cas l'opérateur doit, de sa propre initiative, décaler vers un rang suivant les chiffres au moment de l'introduction du code, afin d'y affecter les rangs des unités, des dizaines etc. Ce générateur est donc d'un usage mal commode.

L'invention a donc pour but de perfectionner le générateur séquentiel de codage du type défini au début du présent mémoire et qui est caractérisé en ce que ledit code chiffré est engendré sous forme d'un nombre binaire, en ce que ladite mémoire est un compteur binaire et en ce qu'il est prévu des moyens pour la remise à zéro de ladite mémoire après chacune desdites séquences de codage successives.

Il résulte de ces caractéristiques que les dimensions du générateur sont limitées pratiquement à celles de l'organe manuel de commande pour autant naturellement que les circuits électroniques qui lui sont associés soient miniaturisés ou en soient géographiquement séparés. Par ailleurs, le code binaire peut être composé d'une suite de nombres d'une longueur quelconque et composés de chiffres quelconques en fonction du nombre de séquences de codage successives que l'opérateur aura lui-même choisi. L'organe manuel de commande n'est donc nullement lié à une information qui lui est propre, cette information pouvant être choisie librement au gré de l'opérateur.

L'invention a également pour objet un dispositif de commande sous condition d'une action telle que l'ouverture d'une serrure, par exemple, ce dispositif constituant une application du générateur séquentiel de code binaire défini ci-dessus.

L'invention est exposée ci-après plus en détail à l'aide de dessins représentant seulement les modes d'éxécution, sur lesquels :

- la Fig. 1 est un schéma simplifié d'un dispositif de commande utilisant un générateur séquentiel de code binaire selon l'invention;

- les Fig. 2A et 2B représentent ensemble un schéma détaillé du dispositif de commande de la Fig. 1;

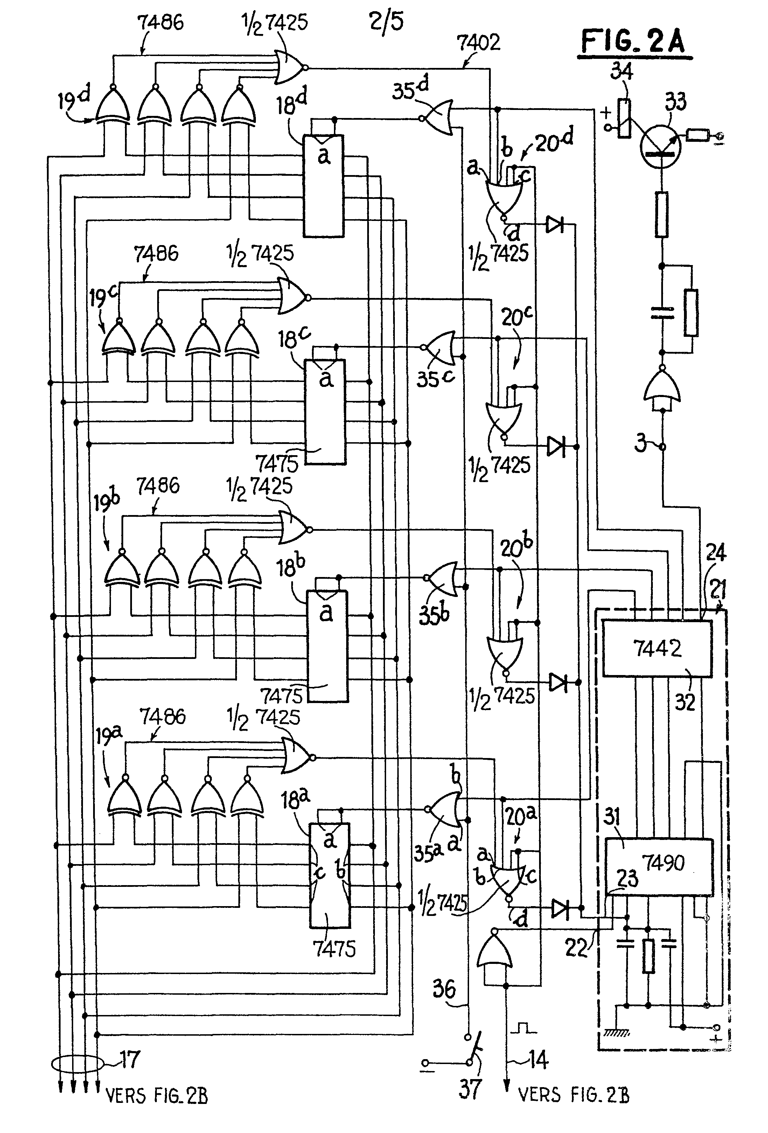

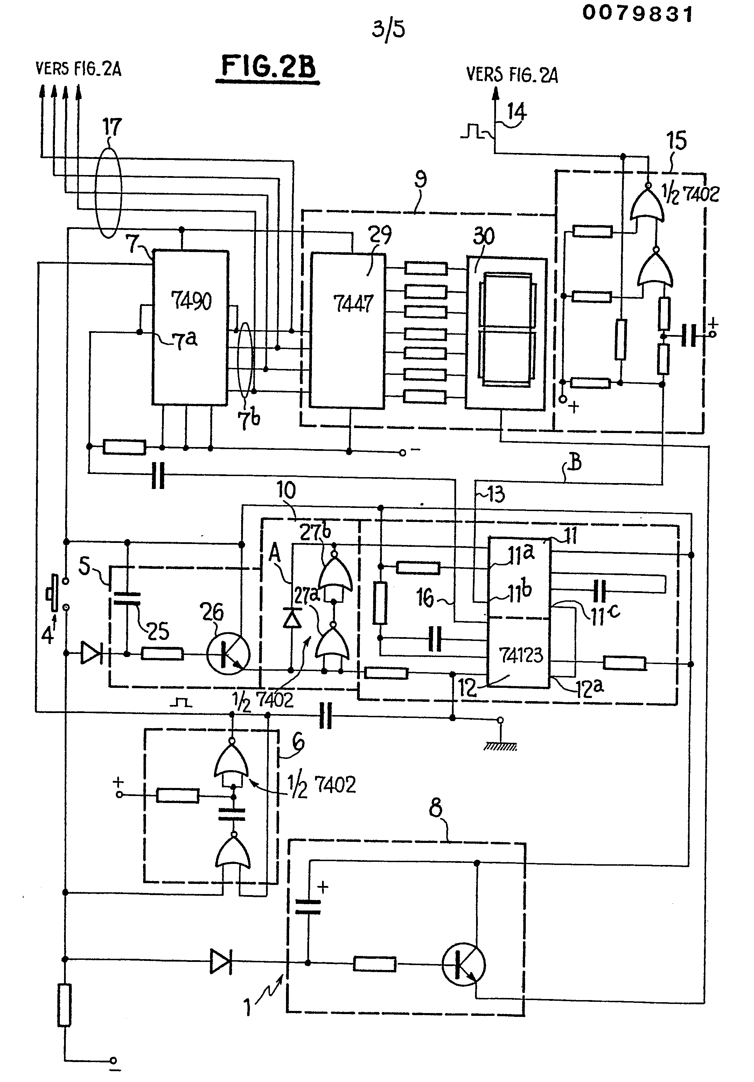

- la Fig. 3 est un graphique qui montre l'allure d'un signal caractéristique apparaissant dans le générateur

4

de la Fig.2A et illustrant le fonctionnement de celui-ci.

- la Fig.4 est une variante d'une partie du dispositif de commande.

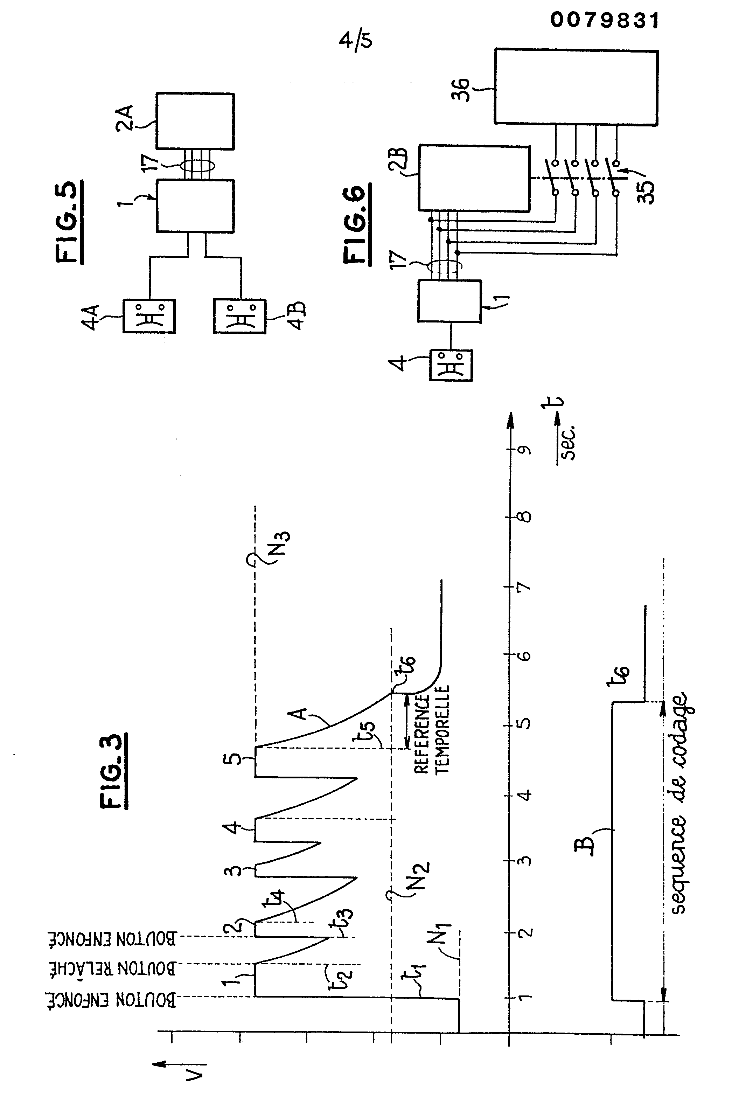

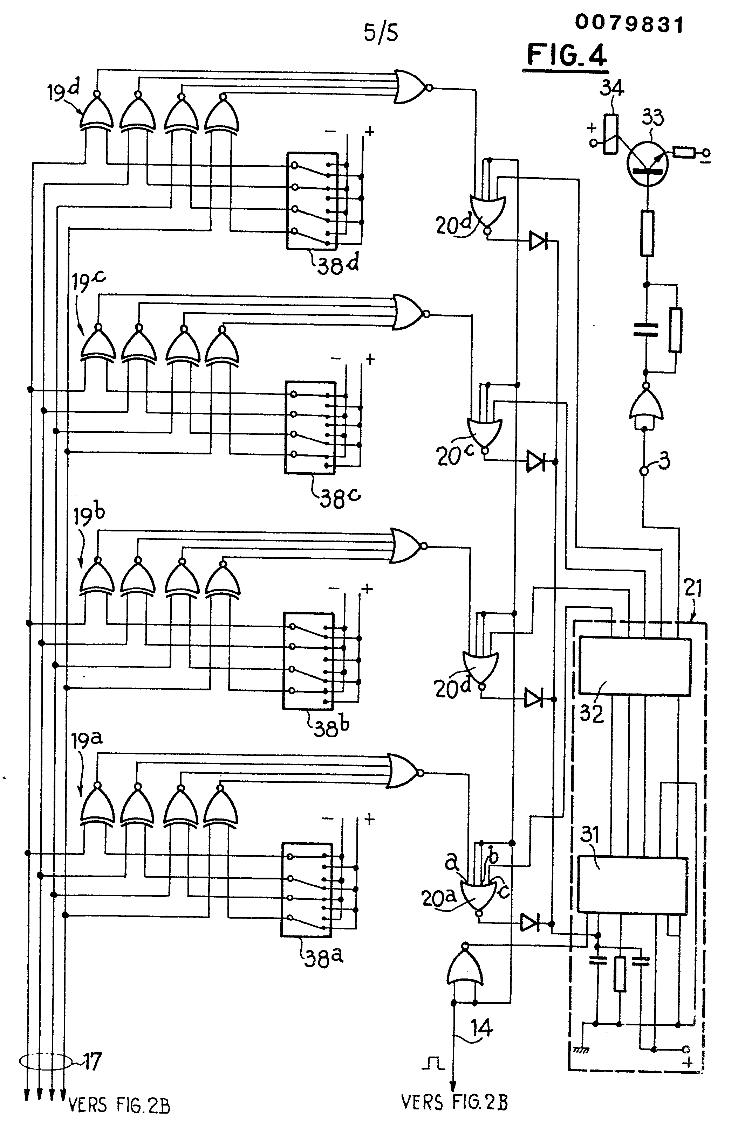

- les Fig.5 et 6 montrent deux variantes possibles d'application du générateur suivant l'invention.

On va maintenant décrire un exemple de réalisation d'un générateur séquentiel selon l'invention dans son application à un dispositif de commande sous condition d'une action, telle que par exemple l'ouverture sous condition d'une serrure. On verra dans ce qui va suivre que l'invention n'est pas limitée à cette application particulière.

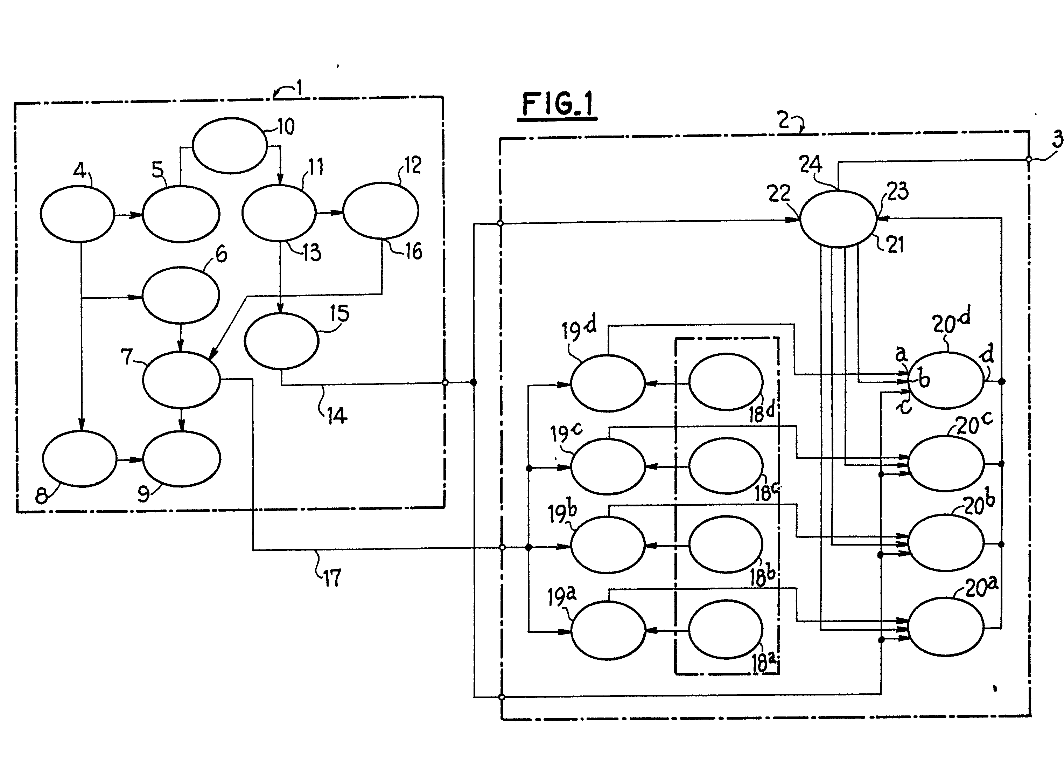

Sur la Fig.1, on voit que le dispositif de commande sous condition comprend un générateur de code 1 suivant l'invention et des moyens d'analyse 2 capable de comparer le code engendré par ce générateur à une valeur mémorisée afin de déclencher un signal d'autorisation sur une borne 3. Ce signal peut être exploité de toute manière voulue par exemple pour exciter un relais, déclencher un vérin, etc. Une application particulière concerne les serrures utilisées dans le bâtiment, dans les véhicules automobiles et autres.

Le générateur de code 1 comprend un organe de commande manuel 4 tel qu'un bouton-poussoir ou tout autre organe analogue, permettant à un opérateur d'introduire le code nécessaire pour déclencher l'action souhaitée. Le bouton-poussoir 4 est raccordé à un générateur 5 de référence temporelle et à un circuit 6 de mise en forme d'impulsions, lui-même raccordé à une mémoire 7 de nombre de code. Cette mémoire est de préférence un compteur à décade enregistrant, au cours de chaque séquence de fonctionnement du générateur de code 1, le nombre d'actionnements du bouton-poussoir 4.

Celui-ci est également connecté à un circuit 8 de commande d'affichage capable d'exciter un dispositif d'affichage 9 pendant un temps prédéterminé, à chaque actionnement du bouton-poussoir 4. Le dispositif d'affichage reçoit l'information numérique à afficher du compteur 7.

Le bouton-poussoir 4 est également relié à un circuit de détection 10 qui est capable de fournir un signal de fin de séquence de codage lorsqu'il constate que le temps consécutif à la fin d'un actionnement déterminé du bouton-poussoir 4 (c'est-à-dire son relâchement) dépasse la référence temporelle fixée dans le générateur 5. Le circuit de détection est connecté à un circuit de validation 11, 12 qui comporte une première sortie 13 pour la transmission d'un ordre d'analyse par l'intermédiaire d'une ligne 14 aux moyens d'analyse 2, cet ordre d'analyse étant d'abord mis en forme dans un circuit de mise en forme 15.

Le circuit de détection 11, 12 est également pourvu d'une seconde sortie 16 pour transmettre un ordre de remise à zéro au compteur à décade 7 après chaque séquence de codage. Ce compteur à décade est relié aux moyens d'analyse 2 par une ligne 17 sur laquelle sont transférées les informations relatives aux nombres codés au cours de chaque séquence de codage ( sortie du générateur).

Les moyens d'analyse 2 comprennent un jeu $n$ de mémoires (quatre en l'occurence) 18a à 18d qui sont connectées respectivement à autant de comparateurs 19a à

19d et qui sont destinées à mémoriser chacune un nombre de la valeur à laquelle le code introduit par l'opérateur doit satisfaire pour que l'action souhaitée soit déclenchée (signal sur la borne 3). Les comparateurs 19a à 19d sont connectés en parallèle à la sortie du compteur à décade 7 par la ligne 17 pour recevoir le nombre codé au cours de chaque séquence de codage. Ils sont également raccordés par leurs sorties à des premières entrées a de circuits de verrouillage respectifs 20a à 20d qui peuvent sélectivement être adressés sur des entrées b par un séquenceur d'analyse 21 formé par un compteur dont l'entrée de comptage 22 est raccordée à la ligne 14.

Les troisièmes entrées c des circuits de verrouillage 20a à 20d sont également connectées à la ligne 14 pour la transmission de l'ordre de comparaison, pour chaque nombre de code à comparer aux nombres mémorisés dans les mémoires 18a à 18d.

Les sorties d des circuits de verrouillage sont raccordées en parallèle à une entrée de remise à zéro 23 du compteur ou séquenceur 21 qui est ainsi remis à zéro chaque fois qu'un nombre codé ne correspond pas au nombre mémorisé dans les mémoires 18a à 18d. Le compteur 21 comporte également une sortie de débordement 24 sur laquelle apparaît un signal de déclenchement d'action lorsqu'il est complètement rempli.

A ce stade de la description, on notera que le dispositif ne se limite nullement à une valeur mémorisée à quatre nombres, ni d'ailleurs à une valeur dont chaque nombre est un chiffre décimal entre 1 à 10. Toutefois, le mode de réalisation décrit ici envisage en tant que valeur mémorisée et donc également en tant que valeur de codage un nombre décimal à quatre chiffres dont dans l'exemple décrit ici le premier chiffre est un cinq.

On va maintenant examiner la Fig. 2B sur laquelle il apparaît que le générateur de référence temporelle 5 est un circuit de temporisation comportant un condensateur 25 qui est chargé à la tension d'alimentation à chaque actionnement du bouton poussoir 4 de sorte que l'intervalle de temps représentant la référence temporelle est déclenché à chacun de ces actionnements. Le condensateur 25 est associé à un transistor 26 à l'émetteur duquel apparaît un signal reflétant la sortie du circuit de temporisation 5. Le circuit de détection 10 du franchissement de la référence temporelle est formé par un circuit à seuil composé de deux portes NI en cascade 27a et 27b.

Le circuit de validation comporte un circuit intégré 28 contenant deux bascules monostables 11 et 12. La sortie du circuit de détection 10 est reliée à l'entrée 11a de la bascule 11 dont les sorties 11b et 11c sont respectivement reliées à la ligne ou borne 13 et à l'entrée 12a de la bascule 12. La sortie 12b de celle-ci est reliée à l'entrée 7a de remise à zéro du compteur 7.

Ce compteur présente une sortie 7b sur quatre bits qui est reliée à la ligne 17 et à un décodeur 29 commandant un dispositif 30 d'affichage à sept segments sur lequel apparaît un chiffre représentant au cours de chaque séquence de codage, le nombre d'actionnements du bouton-poussoir 4. Le dispositif d'affichage 30 est activé par le circuit de temporisation 8 de sorte qu'à chaque chiffre affiché, la représentation est évanescente jusqu'à ce que le bouton-poussoir soit de nouveau actionné et le nouveau chiffre affiché avec une clarté décroissante.

La Fig. 3 représente graphiquement le fonctionnement du générateur de code. La courbe A apparaît à la sortie du circuit de détection 10 tandis que la courbe B correspond à la sortie du circuit de validation (sortie 11b de la bascule monostable 11).

Au repos du circuit, le signal A est au niveau bas $N_1$, c'est-à-dire en dessous d'un seuil de tension $N_2$ fixé par les portes NI 27a et 27b. Aucun chiffre n'est affiché et le compteur à décade 7 est à la position zéro.

Si maintenant l'opérateur désire procéder au codage de quatre séquences, il doit successivement actionner le bouton-poussoir 4 autant de fois par séquence que la valeur mémorisée dans les mémoires 13a à 13d l'exige. A supposer que cette valeur est de 5278 par exemple, la première séquence correspond à cinq actionnements du bouton, la seconde à deux, etc,, chaque séquence devant être séparée d'une séquence suivante par un intervalle minimal correspondant à la référence temporelle fixée par le circuit de temporisation 5.

La courbe A de la Fig. 3 représente le déroulement de la première séquence.

Le premier enfoncement du bouton 4 au temps $t_1$ provoque 1) la décharge du condensateur 25 ce qui porte l'entrée du circuit de détection 10 au niveau haut $N_3$ bien supérieur au seuil $N_2$; 2) l'avance du compteur 7 vers la position 1; 3) le déclenchement du circuit de temporisation 8 provoquant l'affichage du chiffre 1 sur le dispositif d'affichage 30 et; 4) le déclenchement de la bascule monostable 11 (courbe B).

Lorsqu'au temps $t_2$, le bouton est relâché, le condensateur 25 peut se charger à travers le transistor 26 et la résistance de base de celui-ci avec une constante de temps prédéterminée fixée par la valeur de ces composants. Il apparaît alors au point A une tension décroissante qui continue à décroître jusqu'à ce qu'au temps $t_3$, le bouton 4 soit de nouveau enfoncé. La tension au point A reprend le niveau $N_3$ en attendant le relâche-

ment du bouton au temps $t_4$. Bien entendu, le nouvel actionnement a provoqué l'avance d'une position du compteur 7 et l'allumage du dispositif d'affichage 30 qui montre avec une intensité décroissante le chiffre 2, grâce au circuit de temporisation 8. En revanche, la bascule monostable 11 reste dans son état déclenchée et la courbe B reste donc au niveau haut.

L'opérateur connaissant le code procédera ainsi à l'introduction du code jusqu'à ce qu'il ait relâché le bouton 4 pour la cinquième fois (temps $t_6$). Il sait qu'ensuite il convient d'attendre pour commencer une prochaine séquence de codage.

Du fait de cette attente , le condensateur 25 a eu le temps de se charger jusqu'à une tension qui fait descendre la tension à l'entrée du circuit de détection 10 en dessous du seuil de tension $N_2$ ce qui fait réagir le circuit de détection car il reçoit sur les deux entrées de sa porte NI 27a un niveau bas de sorte que la bascule monostable 11 est rétablie dans son état initial (temps $t_6$). Ceci valide le chiffre 5 qui est alors codé par l'opérateur, la sortie de la bascule 11 revenant à son état bas initial. Le front descendant de la courbe B provoque alors la production d'une impulsion de durée prédéterminée sur la ligne 14 dont les fronts avant et arrière agissent sur les circuits des moyens d'analyse 2 comme on le verra par la suite. Si l'opérateur appuie sur le bouton une nouvelle fois avant que la tension V ait eu le temps d'atteindre le seuil $N_2$, le circuit interprètera le codage d'un 6 et inversement si l'opérateur attend trop longtemps entre deux actionnements précédents, un chiffre inférieur à 5 sera validé.

Quel que soit le chiffre validé, le compteur 7 transmet la valeur binaire équivalente sur la ligne 17 tandis que la sortie de la bascule monostable 11 est transmise sur la ligne 14 par l'intermédiaire du circuit de mise en forme 15.

Il est à noter que le basculement vers l'état initial de la bascule monostable 11 a provoqué celui de la bascule 12 ce qui a pour effet la remise à zéro du compteur 7 après une période de temps prédéterminée.

La valeur 5278 a été préalablement codée dans les mémoires 18a à 18d, si bien que la mémoire 18a contient le chiffre 5. La valeur binaire de celui-ci est appliquée sur les entrées respectives du comparateur 19a tant à partir de la ligne 17 qu'à partir de cette mémoire 18a de sorte que le comparateur 19a fournit un signal de sortie au circuit de verrouillage 20a indiquant que la comparaison est favorable et que le chiffre correct a été codé. Bien entendu, si l'opérateur a codé un chiffre différent de cinq, cette comparaison s'avère défavorable et le circuit de verrouillage 20a reçoit un signal correspondant sur son entrée a, ce qui provoque la remise à zéro d'un circuit de comptage 31 faisant partie du compteur séquenceur 21 décrit à propos de la Fig. 1. On notera qu'en fait ce compteur séquenceur comporte le circuit de comptage 31 et un circuit de décomptage 32 qui par sa sortie 24 provoque la production du signal d'autorisation de l'action sur la borne 3. L'impulsion transitant sur la ligne 14 et produite par le circuit de mise en forme 15 lorsque la bascule 11 revient à son état initial, provoque par son front montant un ordre de comparaison qui est appliqué aux entrées c. Le front descendant de cette impulsion fait avancer le circuit de comptage 31.

Par ailleurs, chacun des circuits de verrouillage 20a à 20d est adressé sélectivement par le circuit de décomptage 32 pour que chaque séquence de codage soit associée à une mémoire déterminée 18a à 18d des moyens d'analyse 2.

Si à chaque séquence de codage, le nombre ou chiffre correct est codé par l'opérateur, les verrous 20a à 20d sont successivement adressés par le décompteur 32, car dans ces conditions, après chaque séquence le circuit de comptage 31 peut avancer d'une position. Par contre, dès qu'un codage n'est pas correct, le circuit de verrouillage 20a à 20d correspondant fournit un signal de remise à zéro qui replace le circuit de comptage 31 à sa position de départ.

Après un codage correct des quatre nombres par l'opérateur au cours de quatre séquences consécutives se déroulant comme décrites ci-dessus, le circuit de décomptage 32 parvient à exciter la borne 3 ce qui, par exemple par l'intermédiaire d'un transistor de puissance 33 et d'un relais 34, permet de déclencher l'action souhaitée (ouverture d'une serrure par exemple).

On notera que dans l'exemple décrit, la valeur stockée dans les mémoires 18a à 18d est composée de quatre chiffres décimaux. Cependant, moyennant une adaptation de la capacité notamment de ces mémoires et du compteur 7, on pourrait faire en sorte que chaque séquence implique le codage d'un nombre quelconque, supérieur ou inférieur à 10. En outre, la valeur emmagasinée pourrait être composée d'une quantité quelconque d'éléments (supérieure ou inférieure à quatre), en prévoyant le nombre de mémoires correspondantes et les capacités nécessaires du compteur 21.

Le montage représenté sur les Fig. 2A et 2B comporte également des moyens permettant la mise en mémoire d'un nombre dans chacune des mémoires 18a à 18d à l'aide du générateur de code 1.

Sur la Fig. 2A, on voit que les mémoires comportent une entrée a qui lorsqu'elle est activée rend cette mémoire "transparente". En d'autres termes, un nombre binaire appliqué à ces entrées b y est alors emmagasiné.

Les entrées a sont respectivement reliées à une porte NON-ET 35a à 35d dont les entrées a sont connectées en parallèle à une ligne 36 d'introduction de la valeur à mémoriser, à laquelle une tension de polarisation peut être appliquée par un interrupteur 37.

Par conséquent, si l'opérateur veut modifier le code autorisant le déclenchement de l'action souhaitée, il ferme l'interrupteur 37 ce qui conditionne les portes 35a à 35d. L'opérateur procède alors a un codage comme précédemment décrit en choisissant lui-même un code quelconque moyennant quoi les nombres codés sont transférés par la ligne 17 aux entrées b des mémoires 18a à 18d respectivement. Comme dans ces conditions, chaque comparateur 19a à 19d reçoit sur ses deux groupes d'entrées les mêmes signaux binaires, c'est-à-dire ceux provenant de la mémoire 18a à 18d considérée et ceux appliqués par la ligne 17, le compteur 21 adresse successivement en avançant pas-à-pas les portes 35a à 35d sur leur entrée b. Après introduction du nouveau code, l'interrupteur 37 peut être ouvert et le dispositif est alors prêt à fonctionner comme auparavant, mais avec un nouveau code.

Cette possibilité de codage peut trouver une application particulière, lorsqu'il s'agit d'une installation comportant plusieurs dispositifs suivant l'invention pouvant être codés d'un poste central . Un telle installation pourrait être utilisée avantageusement dans un hôtel, par exemple, dans lequel les portes des chambres seraient équipés de dispositifs conformes à celui que l'on vient de décrire. Les interrupteurs 37 pourraient alors être réunis sur un tableau central à la disposition du personnel de l'hôtel pour autoriser le codage de la serrure, soit par ce personnel, soit par le client lui-même. Dans le second cas, celui-ci pourrait être autorisé à composer le code une fois pour toutes ou être autorisé à le modifier à son gré pendant toute la durée de son séjour. Il en résulterait la suppression des clés habituelles.

La Fig.4 montre une variante du dispositif de commande sous condition qui comporte au lieu des mémoires électroniques 18a à 18d, des mémoires électromécaniques à commutateurs 38a à 38d destinés à fournir en permanence un nombre binaire déterminé modifiable en changeant mécaniquement les positions des commutateurs qu'elles contiennent.

La Fig.5 montre un schéma très simplifié d'une variante du générateur de code suivant l'invention. Ce générateur symbolisé par le rectangle 1 est en tous points identique à celui représenté sur les Fig.1 et 2B à cela près qu'il comporte au lieu d'un seul organe manuel de commande, deux de ces organes 4A et 4B raccordés en parallèle sur le circuit du générateur.Le générateur est raccordé par sa sortie 17 à des moyens d'analyse 2A.

La variante de la Fig.5 permet de commander un même générateur de code à partir d'emplacements différents. Ainsi, elle pourrait être utilisée, par exemple, dans une salle de coffres d'une agence bancaire, le personnel de la banque devant tout d'abord introduire une première partie du code à l'aide de l'organe 4A, après quoi, pour  ouvrir un coffre appartenant à un client donné, celui-ci doit introduire à son tour une deuxième partie du code à l'aide de l'organe de commande 4B.

La Fig.6 représente une autre application du générateur de code suivant l'invention dans laquelle celui-ci est raccordé à des moyens d'analyse 2B capable après vérification d'un code introduit par le générateur 1 d'autoriser par un dispositif de commutation 35, le branchement direct du générateur de code 1 à un dispositif d'utilisation 36 qui est destiné à remplir une fonction donnée sous la commande d'un code introduit par le générateur. A titre d'exemple, il peut s'agir ici d'un guichet bancaire de distribution automatique de billets, par exemple. Dans ce cas, l'utilisateur introduira d'abord un code qui lui est propre et qui est vérifié par le circuit 2B, après quoi, il sera autorisé à introduire d'autres informations à l'aide du même organe de commande 4, ces informations passant après fermeture du dispositif de commutation 35, dans le dispositif d'utilisation 36 et représentant par exemple, le montant des billets que l'opérateur désire recevoir, un ordre de virement, une remise de chéques, etc.

Dans l'application que l'on vient de décrire, le générateur de code, suivant l'invention peut donc être utilisé d'une part pour vérifier si une personne est habilitée à exécuter une certaine action ( en l'occurence l'obtention d'une somme en billets de banque ) et d'autre part, pour engendrer une information qui représente la somme souhaitée. D'autres applications de l'invention peuvent conduire à utiliser le générateur uniquement pour engendrer des informations sans qu'il y ait une vérification du code introduit.

Par exemple, le générateur peut être utilisé pour remplacer le cadran de numérotation d'un poste téléphonique, le clavier d'une calculatrice miniature, etc.

- REVENDICATIONS -

1. Générateur séquentiel à commande manuelle, dans lequel un organe unique de commande est destiné à engendrer successivement des impulsions relatives à un code chiffré devant être obtenu au cours de séquences de codage successives, cet organe de codage étant connecté à un générateur d'une référence temporelle à laquelle est confrontée l'intervalle de temps séparant deux actions successives sur l'organe de codage pour permettre d'affecter un rang à chaque chiffre dudit code choisi à chaque séquence, le générateur comportant en outre une mémoire destinée à emmagasiner le nombre d'impulsions engendrées au cours de chaque séquence, caractérisé en ce que ledit code chiffré est engendré sous forme d'un nombre binaire, en ce que ladite mémoire (7) est un compteur binaire et en ce qu'il est prévu des moyens (16) pour la remise à zéro de ladite mémoire après chacune desdites séquences de codage successives .

2. Générateur suivant la revendication 1, caractérisé en ce que ledit générateur de référence temporelle est un circuit de temporisation (5) dont le cycle de temporisation est déclenché chaque fois qu'un actionnement de l'organe manuel de commande (4) est achevé.

3. Générateur suivant la revendication 2, caractérisé en ce que le circuit de temporisation (5) comporte des moyens (25,26) pour engendrer une tension variable à chaque fin d'actionnement sur ledit organe manuel de commande, et en ce que lesdits moyens de détection (10) comprennent un circuit à seuil de tension $(N_2)$ fournissant ledit signal de fin de séquence lorsque ladite tension franchit ce seuil dans un sens prédéterminé.

4. Générateur suivant l'une quelconque des revendications 1 à 3, caractérisé en ce que ladite mémoire (7) est connectée à un dispositif de signalisation (9, 29,30) de type optique, par exemple, pour  signaler la fin d'une séquence de codage.

5. Générateur suivant la revendication 4, caractérisé en ce que ledit dispositif de signalisation est un circuit d'affichage numérique (9,29,30) pour afficher le nombre contenu dans ladite mémoire (7), chaque fois que ledit organe de commande (4) est actionné.

6. Générateur suivant la revendication 5, caractérisé en ce que le circuit d'affichage (9,29,30) est alimenté à travers un circuit temporisateur (8) pour rendre l'affichage évanescent après chaque actionnement de l'organe de commande (4).

7. Générateur suivant l'une quelconque des revendications 1 à 6, caractérisé en ce qu'il comprend plusieurs organes manuels de commande (4A, 4B) connectés en parallèle et permettant le codage par le générateur à partir d'emplacements distincts.

8. Générateur suivant l'une quelconque des revendications 1 à 7, caractérisé en ce qu'en vue de la vérification du code introduit à l'aide dudit organe manuel de commande (4), il comprend en outre des moyens d'analyse (2) comprenant un jeu de mémoire (18a à 18d) dont les sorties sont raccordées aux premières entrées d'autant de comparateurs (19a à 19d) dont les secondes entrées sont reliées à la mémoire (7) du générateur, les sorties de ces comparateurs étant reliées conditionnellement à un compteur séquenceur (21) par l'intermédiaire de circuits de verrouillage (20a à 20d) adressés sélectivement par le compteur séquenceur en fonction de l'apparition dudit signal de fin de séquence, et en ce que ledit compteur séquenceur (21) comporte une sortie de débordement (24) à laquelle apparaît un signal après vérification de tous les nombres introduits à l'aide de l'organe manuel de commande (4).

9. Générateur suivant la revendication 8, caractérisé en ce que le compteur séquenceur (21) est connecté auxdits circuits de verrouillage (20a à 20d) et auxdits moyens de validation de telle manière qu'il n'avance d'une position que lorsqu'une comparaison entre un nombre de code introduit et un nombre de la valeur mémorisée est correcte et qu'il soit remis à zéro au cas ou cette comparaison établit une inégalité et en ce que ladite sortie de débordement (24) est raccordée à un dispositif de puissance (33,34) permettant le déclenchement sous condition d'une action.

10. Générateur suivant l'une quelconque des revendications 8 et 9, caractérisé en ce que ledit jeu de mémoires(38a à 38d) est du type électro-mécanique.

11. Générateur suivant l'une quelconque des revendications 8 et 9, caractérisé en ce que ledit jeu de mémoires est du type électronique et en ce qu'il est prévu des moyens (35a à 35d, 36,37) pour autoriser la mise en mémoire de ladite valeur à l'aide dudit générateur de code (1).

12. Générateur suivant l'une quelconque des revendications 8 à 11, caractérisé en ce que lesdits moyens d'analyse (2B) sont associés à un dispositif de commutation (35) autorisant, après vérification d'un code introduit à l'aide dudit organe manuel de commande, le branchement du générateur sur un dispositif d'utilisation (36) des nombres introduits ultérieurement.

0079831

FIG.1

FIG. 2A

**FIG.2B**

VERS FIG.2A

VERS FIG.2A

## FIG.3

BOUTON ENFONCÉ
BOUTON RELÂCHÉ
BOUTON ENFONCÉ

RÉFÉRENCE TEMPORELLE

séquence de codage

## FIG.5

## FIG.6

0079831

0079831

## FIG.4

19d
38d
19c
38c
19b
38b
19a
38a
20d
20c
20d
20a a b c
14
17
VERS FIG.2B
VERS FIG.2B
34
33
3
21
32
31

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| X | DE-A-3 014 725 (SCHOLICH) *Figures 4,5,6,7; page 4, ligne 25 - page 7, dernière ligne* | 1,2,11 | H 03 K 13/24 G 05 B 19/10 |
| | --- | | |
| X | US-A-4 197 524 (SALEM) *Figures 2,3,4,5,6; colonne 4, ligne 48 - colonne 8, ligne 35* | 1,11 | |
| | --- | | |
| D,Y | DE-A-2 952 212 (LÜBKE) *Figures 1,2; colonne 1, ligne 56 - colonne 2, ligne 40; colonne 3, ligne 7; colonne 4, ligne 45 - colonne 6, ligne 57* | 1,2,10 | |
| | --- | | |
| D,Y | US-A-3 681 574 (CAUCKLIN) *Figures 1,2; colonne 1, ligne 42 - colonne 2, ligne 52* | 1-3,11 | DOMAINES TECHNIQUES RECHERCHES (Int. Cl. 3) |
| | --- | | |
| D,A | US-A-4 250 401 (SUMIDA) *Figures 1,2,3; colonne 2, ligne 24 - colonne 6, ligne 22* | 1-4,5 11 | H 03 K G 05 B E 05 B |
| | --- | | |
| A | GB-A-2 013 381 (PHILIPS) *Figures 1-7,14-17; page 1, ligne 6 - page 4, ligne 97; page 7, ligne 53 - page 8, ligne 106* | 1,2,4, 5 | |
| | --- -/- | | |

Le présent rapport de recherche a été établi pour toutes les revendications

| Lieu de la recherche LA HAYE | Date d'achèvement de la recherche 25-02-1983 | Examinateur FEUER F.S. |
|---|---|---|

Office européen
des brevets

**RAPPORT DE RECHERCHE EUROPEENNE**

EP 82 40 2067

| | **DOCUMENTS CONSIDERES COMME PERTINENTS** | | Page 2 |
|---|---|---|---|
| Catégorie | Citation du document avec indication, en cas de besoin, des parties pertinentes | Revendication concernée | CLASSEMENT DE LA DEMANDE (Int. Cl. ³) |
| P | EP-A-0 047 486 (STÖSSER) *Figures 1,3; page 1, ligne 31 - page 2, ligne 10; page 7, ligne 13 - page 9, ligne 23* ----- | 1,11 | |
| | | | **DOMAINES TECHNIQUES RECHERCHES (Int. Cl. ³)** |

Le présent rapport de recherche a été établi pour toutes les revendications

| Lieu de la recherche LA HAYE | Date d'achèvement de la recherche 25-02-1983 | Examinateur FEUER F.S. |
|---|---|---|